# EUROPEAN PATENT APPLICATION

(11) **EP 3 121 613 A1**
(43) Date of publication of application: **25.01.2017**
(21) Application number: 15765817.0
(22) Date of filing: 06.03.2015
(51) Int. Cl.: G01R 31/36, H01M 10/48, H02J 7/00

(54) **DEGRADATION ESTIMATION METHOD, DEGRADATION ESTIMATION SYSTEM, AND DEGRADATION ESTIMATION PROGRAM**

(30) Priority: 18.03.2014 JP 2014055630
(71) Applicant: Kabushiki Kaisha Toshiba, Minato-ku Tokyo 105-8001 (JP)
(72) Inventor: UCHIDA, Katsuya, Tokyo 105-8001 (JP); KOSUGI, Shinichiro, Tokyo 105-8001 (JP); SATO, Makoto, Tokyo 105-8001 (JP); MATSUOKA, Makoto, Tokyo 105-8001 (JP); TSUKAHARA, Hiroyuki, Tokyo 105-8001 (JP)
(74) Representative: Awapatent AB
(86) International application number: PCT/JP2015/056708
(87) International publication number: WO 2015/141500

(57) **Abstract**

A degradation estimation method includes detecting a stop interval of a battery control apparatus having a function to calculate a state of charge of a battery, acquiring degradation information corresponding to a calculated state of charge calculated from the battery and a detection temperature detected from the battery or degradation information corresponding to the calculated state of charge and an ambient temperature based on a first degradation information database showing degradation of the battery in accordance with a set state of charge and a set temperature, and estimating the degradation of the battery in the stop interval based on the degradation information acquired.

## Description

### FIELD

The present invention relates to a degradation estimation method, a degradation estimation system, and a degradation estimation program.

### BACKGROUND

A secondary battery gradually degrades after the manufacture thereof and deterioration of characteristics such as a decrease in capacity and a rise in resistance occurs. The degradation of a battery affects the system using the battery and if the level of degradation is high, the battery capacity or output characteristics needed by the system may not be satisfied and the system operation may be stopped and thus, it is important to estimate the degradation of a battery. That is, the system using a battery desirably detects the life of the battery. It is known that the degradation speed of a battery changes depending on how the battery is used (such as the ambient temperature and the charge/discharge range) and some methods of estimating the degradation of the battery have been proposed.

### CITATION LIST

### PATENT LITERATURES

Patent Literature 1: Jpn. Pat. Appln. KOKAI Publication No. 2002-236154
Patent Literature 2: Jpn. Pat. Appln. KOKAI Publication No. 2010-22155

### SUMMARY

### TECHNICAL PROBLEM

However, it is not easy to estimate the life of a battery. For example, it is difficult to calculate the life of a battery by considering even a case when an apparatus monitoring the battery is stopped. It is also difficult to calculate the life of a battery by considering differences of the degradation speed due to different charge/discharge SOC (state of charge) ranges.

An object of the present invention is to provide a degradation estimation method, a degradation estimation system, and a degradation estimation program superior in battery degradation estimation.

### SOLUTION TO PROBLEM

An example of a degradation estimation method according to an embodiment detects a stop interval of a battery control apparatus having a function to calculate a state of charge of a battery acquires degradation information corresponding to a calculated state of charge calculated from the battery and a detection temperature detected from the battery or degradation information corresponding to the calculated state of charge and an ambient temperature based on a first degradation information database showing degradation of the battery in accordance with a set state of charge and a set temperature, and estimates the degradation of the battery in the stop interval based on the degradation information acquired.

### BRIEF DESCRIPTION OF THE DRAWINGS

FIG. 1A is a block diagram showing an example of a battery control system.
FIG. 1B is a diagram showing another example of a coefficient table (first degradation information database) to calculate degradation of a battery.
FIG. 2 is a block diagram showing an example of a battery control system according to Embodiment 1-1.
FIG. 3 is a block diagram showing an example of a battery control system according to Embodiment 2.
FIG. 4A is a block diagram showing an example of a battery control system according to Embodiment 4-1.
FIG. 4B is a diagram showing an example of a degradation coefficient table (table gathering coefficients for each temperature/SOC) to calculate degradation of a battery while the charge/discharge is stopped.
FIG. 4C is a diagram showing an example of a coefficient table (second degradation information database) to calculate degradation of a battery while being charged/discharged.
FIG. 5 is a block diagram showing an example of a battery control system according to Embodiment 5-1.
FIG. 6A is a block diagram showing an example of a battery control system according to Embodiment 6-1.
FIG. 6B is a diagram showing an example of a use condition map showing conditions for using the battery for each temperature/SOC.
FIG. 7 is a block diagram showing an example of a battery control system according to Embodiment 6-2-2.
FIG. 8 is a diagram showing an example creating a use condition map.
FIG. 9 is a diagram showing an example creating a use condition map.
FIG. 10 is a diagram showing an example of the use condition map.
FIG. 11 is a diagram showing an example of temperature data.
FIG. 12 is a diagram showing an example of the use condition map.
FIG. 13 is a diagram showing an example of an internal resistance map.
FIG. 14 is a diagram showing an example of a table showing temperature rise coefficients.
FIG. 15 is a diagram showing an example of an outline configuration of a computer.
FIG. 16 is a diagram showing another example of the use condition map showing conditions for using the battery for each temperature/SOC.

### DETAILED DESCRIPTION

Hereinafter, the embodiments will be described with reference to the drawings. Blocks of the same name in each diagram can perform substantially the same operation.

### (Concept common to each embodiment)

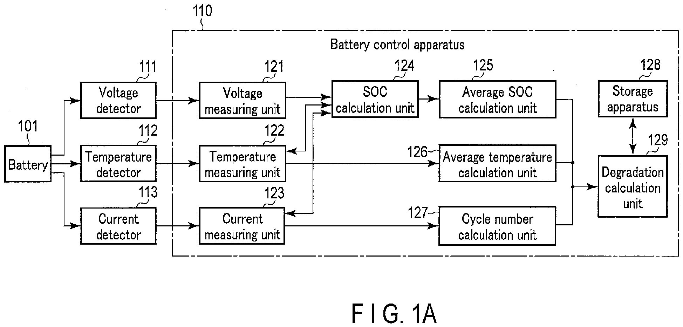

FIG. 1A is a block diagram showing an example of a battery control system. As shown in FIG. 1A, the battery control system includes a battery control apparatus 110, a voltage detector 111, a temperature detector 112, and a current detector 113. The battery control apparatus 110 includes a voltage measuring unit 121, a temperature measuring unit 122, a current measuring unit 123, an SOC calculation unit 124, an average SOC calculation unit 125, an average temperature calculation unit 126, a cycle number calculation unit 127, a storage apparatus 128, and a degradation calculation unit 129.

Incidentally, the battery 101 may be configured as one cell or a battery pack in which a plurality of cells is connected in series or in parallel.

The battery control apparatus 110 controls the charge and discharge of the battery 101. The battery control apparatus 110 acquires the voltage, temperature, and current of the battery 101 through the voltage detector 111, the temperature detector 112, and the current detector 113 that measure the voltage, temperature, and current of the battery 101 respectively. That is, the voltage measuring unit 121 measures the voltage value based on a voltage detection value from the voltage detector 111, the temperature measuring unit 122 measures the temperature value based on a temperature detection value from the temperature detector 112, and the current measuring unit 123 measures the current value based on a current detection value from the current detector 113. Incidentally, the voltage detector 111, the temperature detector 112, and the current detector 113 may be mounted inside the battery control apparatus.

The SOC calculation unit 124 calculates (estimates) SOC from the acquired voltage, temperature, and current of the battery 101. For this calculation method, techniques of current integration, an estimation calculation from the voltage and the like can be applied. Incidentally, SOC means a state of charge (the charged amount, charging rate or the like).

The storage apparatus 128 holds coefficients (degradation information) to calculate (estimate) degradation of the battery 101 and the degradation calculation unit 129 calculates (estimates) degradation of the battery 101 from the coefficients, the average temperature calculated (detected) by the average temperature calculation unit 126, the average SOC calculated by the average SOC calculation unit 125, and the number of cycles calculated by the cycle number calculation unit 127. In the present embodiment, the degradation calculation of a battery corresponds to degradation estimation of a battery. The storage apparatus 128 may be a memory in a microcomputer inside the battery control apparatus 110 and if data should be held by straddling power-ON/OFF of the microcomputer, a nonvolatile memory such as EEPROM.

Coefficients to calculate degradation of a battery (first degradation information database)

Here, as degradation of a battery, a decrease in capacity, a rise in resistance, and an increase in thickness are taken as examples. The degradation speed of these changes depending on circumstances (the temperature and charging rate) in which the battery is placed and each is held as a coefficient. Coefficients held in the storage apparatus 122 are held by being put together in a coefficient table. From a plurality of coefficient tables, a combination of respective changes of the battery capacity/resistance/thickness per unit time when the battery 101 is in a certain SOC at a certain temperature and a combination of respective changes of the battery capacity/resistance/thickness per charge/discharge of the battery 101 can be determined.

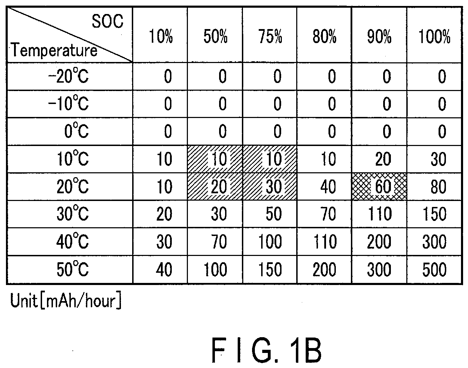

FIG. 1B is a diagram showing an example of a coefficient table (first degradation information database) to calculate changes in battery capacity. As shown in FIG. 1B, the coefficient table contains coefficients showing degradation of a battery in accordance with a plurality of states of charge and temperatures set arbitrarily. When a value is not found in the coefficient table shown in FIG. 1B (for example, the temperature is 15 degrees or the SOC is 20%), numerical values on a degradation trend can be calculated using an approximation. The approximation may be a linear approximation or a curve-fitting approximation like a polynomial approximation.

[mAh/hour] (absolute value of the capacity decreasing per hour) is selected as the unit for changes of values in FIG. 1B, but [%/hour](ratio of the capacity decreasing per hour to the initial value) may also be adopted.

The storage apparatus 128 also holds coefficient tables to similarly calculate changes of the resistance and thickness of the battery 101.

### Calculation of changes of battery characteristics

The battery capacity is taken as an example and how to calculate a decrease in capacity from the coefficient table will be described. As described above, the battery control apparatus 110 calculates the average temperature and the average SOC. When, for example, the battery control apparatus 110 calculates a decrease in capacity once per hour and the average temperature per hour is 20°C and the average SOC is 90% at some time, the degradation calculation unit 129 can calculate that the capacity decreases by 60 mAh based on the coefficient table in FIG. 1B. When the average temperature becomes 15°C and the average SOC becomes 55%, the degradation calculation unit 129 can calculate the coefficient of 15°C, 55% by a linear approximation from values of 10°C, 20°C and 50%, 75% based on the coefficient table in FIG. 1B. For example, the value of 20°C, 55% can be calculated as "(((value of 20°C, 75%) - (value of 20°C, 50%)) / (75-50)) * (55-50) + (value of 20°C, 50%)", that is, 22. By repeating this type of calculation, "16" can be obtained as the value of 15°C, 55%. Thus, a decrease of 16 mAh in capacity can be calculated.

The degradation calculation unit 129 can similarly perform calculations concerning the cell thickness and resistance.

As described above, the battery control apparatus 110 has, as a prerequisite, the degradation speed in accordance with the distribution of SOC/temperature of the battery 101 as a coefficient table or a formula and a function to calculate degradation of the battery 101 in accordance with the SOC/temperature where the battery 101 is used.

Supplementary comments about SOC 100% will be provided. For example, the maximum SOC in terms of performance of the battery 101 may be defined as SOC 100% or any value lower than the maximum SOC may be defined as SOC 100%. Similarly, the minimum SOC in terms of performance of the battery 101 may be defined as SOC 0% or any value higher than the minimum SOC may be defined as SOC 0%. For example, a first voltage value (>0) to a second voltage value (>first voltage value) of the battery 101 may be defined as SOC 0% to SOC 100%.

### (Embodiment 1-1) Information complemented the host system (corresponding to a stop monitoring apparatus or a stop interval detection apparatus) including a battery monitoring function

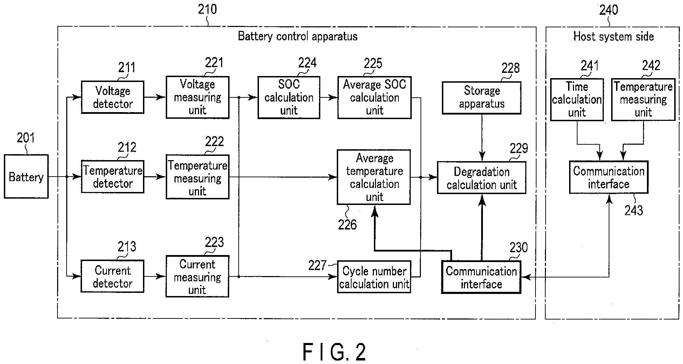

As shown in FIG. 2, FIG. 2 is a block diagram showing an example of a battery control system according to Embodiment 1-1. As shown in FIG. 2, the battery control system includes a battery control apparatus 210 and a host system 240. The battery control apparatus 210 includes a voltage detector 211, a temperature detector 212, a current detector 213, a voltage measuring unit 221, a temperature measuring unit 222, a current measuring unit 223, an SOC calculation unit 224, an average SOC calculation unit 225, an average temperature calculation unit 226, a cycle number calculation unit 227, a storage apparatus 228, a degradation calculation unit 229, and a communication interface 230. The host system 240 includes a time calculation unit 241, a temperature measuring unit 242, and a communication interface 243.

In the battery control system, the host system 240 measures the time and the temperature while the battery control apparatus 210 is stopped and when the battery control apparatus 210 is restarted, the host system 240 sends measurement results of the time and the temperature while the battery control apparatus 210 is stopped to the battery control apparatus 210. Accordingly, the battery control apparatus 210 can acquire measurement results of the time and the temperature while stopped and reflect the acquired measurement results in a degradation calculation.

Regarding the stop interval, for example, the time calculation unit 241 of the host system 240 records a stop time of the battery control apparatus 210 and calculates the stop interval from a difference between a restart time when the battery control apparatus 210 is restarted and the stop time. To determine whether the battery control apparatus 210 is operating, the host system 240 may monitor communication (response) from the battery control apparatus 210 or monitor the condition of power line to the battery control apparatus 210. Regarding the temperature, the host system 240 may monitor and record the battery temperature by attaching a temperature logger to the battery 201 or while the battery control apparatus 210 is stopped, that is, when not charged/discharged, the battery temperature is approximately equal to the ambient temperature and thus, the temperature of the environment in which the battery 201 is placed may be monitored and recorded. The communication interface 230 of the battery control apparatus 210 is notified of the stop interval of the battery control apparatus 210 and the temperature while stopped measured by the host system 240 via the communication interface 243. When notified, the temperature may be the average value, the maximum value, or the minimum value of measured temperatures.

When restarted after being stopped, the battery control apparatus 210 acquires the stop interval and the temperature from the host system 240 via the communication interface 230. The degradation calculation unit 229 calculates degradation of the battery 201 based on the acquired stop interval and temperature data while stopped via the communication interface 230.

If the self-discharged amount of a battery is small regarding SOC while the battery control apparatus 210 is stopped, degradation of the battery 201 is calculated as described below:
(1) Record SOC when the storage apparatus 228 of the battery control apparatus 210 is stopped and when restarted, the degradation calculation unit 229 calculates degradation of the battery 201 by using SOC when stopped as the average SOC.
(2) The communication interface 230 of battery control apparatus 210 notifies the host system 240 of the SOC when stopped, the host system 240 records the notified SOC when stopped, the battery control apparatus 210 receives the SOC when stopped recorded in the host system 240 when restarted, and the degradation calculation unit 229 calculates degradation of the battery 201 using the received SOC when stopped as the average SOC.

If the self-discharged amount of a battery is large, the degradation calculation unit 229 may calculate degradation by adopting the average value of SOC when stopped and SOC when restarted as the average SOC, calculate degradation by adopting the larger value of SOC when stopped and SOC when restarted as the average SOC, or calculate degradation by adopting the smaller value of SOC when stopped and SOC when restarted as the average SOC. For example, SOC when restarted may be calculated by the battery control apparatus 210 from the "voltage of battery when restarted" and the "relationship between the voltage held in advance and SOC" or by the battery control apparatus 210 from the "SOC when stopped" and the "relationship between the temperature acquired from above and the self-discharged amount".

### (Embodiment 1-2)

The battery control apparatus 210 may calculate the average value or the maximum value of the temperature while the battery control apparatus 210 is stopped without calculating the average value or the maximum value of the temperature while stopped by the host system 240. In this case, the host system 240 holds a plurality of pieces of temperature data (in, for example, a storage apparatus inside the host system) and sends all temperature data to the battery control apparatus 210 after the battery control apparatus 210 is restarted, the average temperature calculation unit 226 of the battery control apparatus 210 calculates the average temperature based on the plurality of pieces of temperature data received, and the degradation calculation unit 229 calculates degradation based on the average temperature. Incidentally, the battery control apparatus 210 may include a maximum temperature calculation unit or a minimum temperature calculation unit.

### (Embodiment 2) Time measurement using a timer (corresponding to a stop interval detection apparatus) of the battery control apparatus (without relying on the host system)

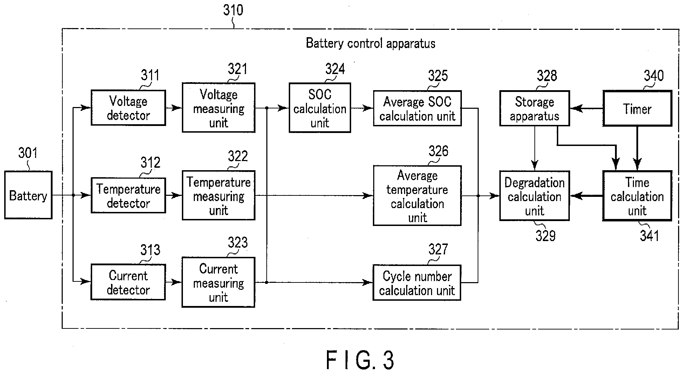

As shown in FIG. 3A, FIG. 3A is a block diagram showing an example of a battery control system according to Embodiment 2. As shown in FIG. 3A, the battery control system includes a battery control apparatus 310 and the battery control apparatus 310 includes a voltage detector 311, a temperature detector 312, a current detector 313, a voltage measuring unit 321, a current measuring unit 323, an SOC calculation unit 324, an average SOC calculation unit 325, an average temperature calculation unit 326, a cycle number calculation unit 327, a storage apparatus 328, a degradation calculation unit 329, a timer 340, and a time calculation unit 341.

In Embodiment 2, the battery control apparatus 310 alone calculates degradation of a battery 301 while the battery control apparatus 310 is stopped without relying on the host system. Thus, the battery control apparatus 310 has a timer 340 capable of measuring the time. If the timer 340 is also stopped while the battery control apparatus 310 is stopped, the time while stopped cannot be measured and thus, the timer 340 is not stopped. The timer can also operate while the battery control apparatus 310 is stopped. That is, the battery control apparatus 310 is being stopped means being in an operation in low-power mode (sleep mode) instead of the battery control apparatus 310 as a whole is stopped and during operation in low-power mode, devices of high power consumption (ex. the microcomputer) are stopped and devices of low power consumption including the timer 340 are not stopped. When the battery control apparatus transitions from the normal mode to the low-power mode, the timer 340 records the start time of the low-power mode in the storage apparatus 328. For example, the storage apparatus 328 is desirably a nonvolatile memory (ex. EEPROM) so that data is not lost during execution of the low-power mode. In response to the return to the normal mode from the low-power mode, the time calculation unit 341 acquires the return time from the timer 340 and calculates a stop interval (execution time of the low-power mode) from a difference between the start time recorded in the storage apparatus 328 and the return time. The temperature and SOC when returned from the low-power mode may be adopted as the temperature and SOC to calculate degradation or the temperature and SOC when transitioned to the low-power mode may be recorded in the storage apparatus 328 so that the average values, the maximum values, or the minimum values of the temperature and SOC when returned and the temperature and SOC when transitioned are adopted as the temperature and SOC to calculate degradation.

### (Embodiment 3) Stop interval calculation by calculation of the battery control apparatus (without relying on the host system)

In Embodiment 3, the battery control apparatus calculates a stop interval without relying on the host system. For example, the stop interval is calculated by software of the battery control apparatus. Thus, the time calculation unit 341 can calculate a stop interval without a timer.

The storage apparatus 328 holds the "relationship between the voltage and SOC" and the "relationship between the temperature, SOC, and self-discharging rate" in advance acquired as characteristics of the battery 301. The battery control apparatus 310 (storage apparatus 328) records the voltage of the battery 301 when stopped and the battery control apparatus 310 (time calculation unit 341) uses when restarted the voltage of the battery and the "relationship between the voltage and SOC" and the "relationship between the temperature, SOC, and self-discharging rate" held in advance in the storage apparatus 328. For example, the time calculation unit 341 calculates a stop interval according to the procedure shown below when restarted.
(1) Calculate SOC when stopped from the voltage when stopped and the "relationship between the voltage and SOC".
(2) Calculate SOC when restarted from the voltage when restarted and the "relationship between the voltage and SOC".
(3) Calculate a stop interval by "SOC difference ÷ self-discharging rate" from a difference between SOC when stopped and SOC when restarted calculated in (1) and (2) and the "relationship between the temperature, SOC, and self-discharging rate".

### (Embodiment 4-1) In consideration of differences of the degradation speed due to different charge/discharge SOC ranges

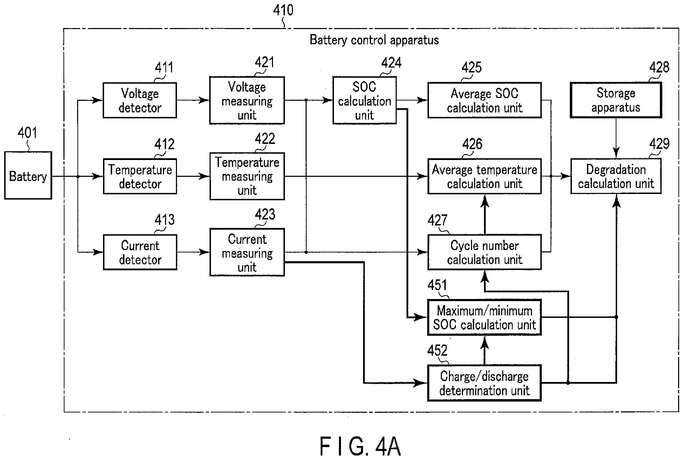

As shown in FIG. 4A, FIG. 4A is a block diagram showing an example of a battery control system according to Embodiment 4-1. As shown in FIG. 4A, the battery control system includes a battery control apparatus 410 and the battery control apparatus 410 includes a voltage detector 411, a temperature detector 412, a current detector 413, a voltage measuring unit 421, a temperature measuring unit 422, a current measuring unit 423, an SOC calculation unit 424, an average SOC calculation unit 425, an average temperature calculation unit 426, a cycle number calculation unit 427, a storage apparatus 428, a degradation calculation unit 429, a maximum/minimum SOC calculation unit 451, and a charge/discharge determination unit 452.

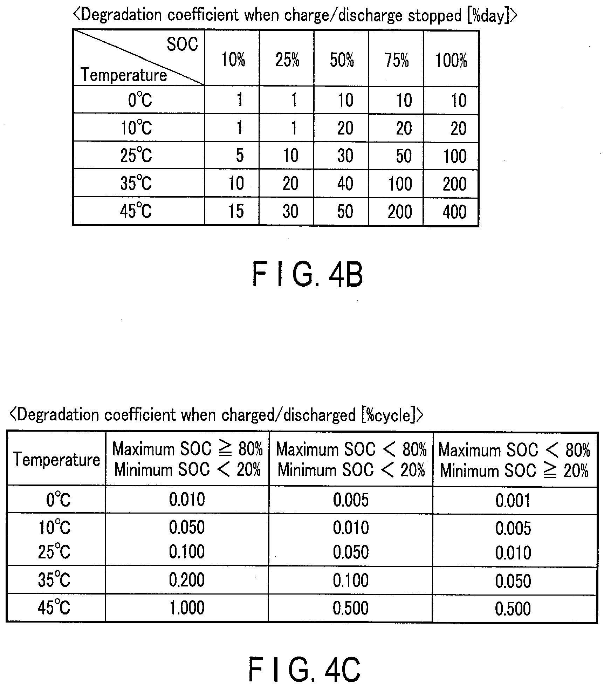

For example, the storage apparatus 428 stores the degradation coefficient table (table gathering coefficients for each temperature/SOC) while the charge/discharge is stopped shown in FIG. 4B and the degradation coefficient table (second degradation information database) when charged/discharged shown in FIG. 4C. As shown in FIG. 4C, the degradation coefficient table contains coefficients showing degradation of a battery in accordance with a plurality of state of charge variation ranges and temperatures set arbitrarily. The battery control apparatus 410 selects the degradation calculation method in accordance with whether being charged/discharged. The charge/discharge determination unit 452 determines when being charged or discharged. For example, the charge/discharge determination unit 452 determines that a current flows (=being charged/discharged) when the measured current value is equal to a fixed value or more and that no current flows (=the charge/discharge is being stopped) when the measured current value is less than the fixed value.

When the charge/discharge is stopped, the degradation calculation unit 429 calculates degradation based on the temperature/SOC distribution of an actual battery and degradation coefficients for each temperature/SOC distribution calculated in advance (FIG. 4B).

The degradation calculation while being charged/discharged will be described. The degradation calculation unit 429 selects the degradation coefficient to be used for degradation calculation in accordance with the SOC range to be charged/discharged. If determined by the charge/discharge determination unit 452 to be in the process of being charged/discharged, the maximum/minimum SOC calculation unit 451 calculates the maximum value and the minimum value of SOC calculated by the SOC calculation unit 424. For example, the following calculation is performed (SOC: SOC calculated by the SOC calculation unit 424, SOCmax: maximum value of SOC, SOCmin: minimum value of SOC):
(1) In response to the detection of the transition by the charge/discharge determination unit 452 from the charge/discharge stop to a state of being charged/discharged, the maximum/minimum SOC calculation unit 451 initializes like SOCmax=SOC and SOCmin=SOC.
(2) In response to the detection of a state of being charged/discharged by the charge/discharge determination unit 452, the maximum/minimum SOC calculation unit 451 sets SOCmax=SOC when SOCmax<SOC (SOCmin is not updated) and sets SOCmin=SOC when SOCmin>SOC (SOCmax is not updated).
(3) In response to the detection of the transition by the charge/discharge determination unit 452 from a state of being charged/discharged to the charge/discharge stop, the maximum/minimum SOC calculation unit 451 determines SOCmax and SOCmin in the charge/discharge.

The cycle number calculation unit 427 converts the charged amount or discharged amount between the time when the charge/discharge determination unit 452 detects the transition from the charge/discharge stop to a state of being charged/discharged and the time when the charge/discharge determination unit 452 detects the transition from a state of being charged/discharged to the charge/discharge stop into the number of cycles. For example, the cycle number calculation unit 427 performs the following calculation (I: current measured value, t: current measurement interval, SOCch: charged amount, SOCdh: discharged amount):
(1) In response to the detection of the transition by the charge/discharge determination unit 452 from the charge/discharge stop to a state of being charged/discharged, the cycle number calculation unit 427 initializes like SOCch=0 and SOCdh=0.
(2) In response to the detection of a state of being charged by the charge/discharge determination unit 452, the cycle number calculation unit 427 calculates SOCch=SOCch (last value) + I × t ÷ coefficient. In response to the detection of a state of being discharged by the charge/discharge determination unit 452, the cycle number calculation unit 427 calculates SOCdh=SOCdh(last value) + I × t ÷ coefficient. Here, the coefficient depends on the current measurement interval t and if the unit of the charged/discharged amount is [Ah] and the unit of t is [s], the coefficient is 3600.
(3) In response to the detection of the transition by the charge/discharge determination unit 452 from a state of being charged/discharged to the charge/discharge stop, the cycle number calculation unit 427 determines SOCch and SOCdh in the charge/discharge.
(4) The cycle number calculation unit 427 calculates the number of cycles by dividing SOCch or SOCdh by a difference between SOCmax and SOCmin, which is viewed as a charged/discharged amount of one cycle.

The storage apparatus 428 stores the degradation coefficient table (table gathering coefficients for each temperature/SOC) while the charge/discharge is stopped shown in FIG. 4B and the degradation coefficient table when charged/discharged shown in FIG. 4C and these degradation coefficient tables includes not only tables in accordance with temperature differences, but also tables in accordance with the maximum SOC and the minimum SOC when charged/discharged.

For example, as shown in FIG. 4C, the storage apparatus 428 stores three patterns of the degradation coefficient table depending on whether the maximum SOC while being charged/discharged is equal to 80% or more and the minimum SOC is less than 20% (naturally, other combinations of degradation coefficient tables may be stored). In the degradation coefficient table shown in FIG. 4C, the unit is %/cycle (what percentage of degradation occurs per cycle).

The degradation calculation unit 429 selects the degradation coefficient table corresponding to the maximum SOC and the minimum SOC calculated by the maximum/minimum SOC calculation unit 451 and selects the degradation coefficient from the average temperature while being charged/discharged calculated by the average temperature calculation unit 426 to calculate a degradation rate. (%) by multiplying by the number of cycles calculated by the cycle number calculation unit 427. Instead of the average temperature, the maximum temperature or the minimum temperature may also be adopted.

### (Embodiment 4-2)

The cycle number calculation unit 427 calculates the number of cycles and [%/cycle] is adopted as the unit of the degradation coefficient stored in the storage apparatus 428, but instead of the number of cycles, a charge/discharge time may also be adopted. The battery control apparatus 410 includes a timer and the timer detects a charge/discharge time. Also, the unit of the degradation coefficient becomes a unit representing a degradation rate over time such as [%/day] and [%/hour].

### (Embodiment 5-1) Notification of a warning when degradation of a battery reaches the threshold

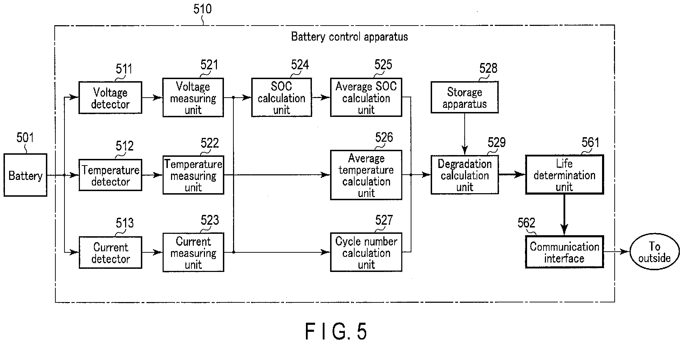

As shown in FIG. 5, FIG. 5 is a block diagram showing an example of a battery control system according to Embodiment 5-1. As shown in FIG. 5, the battery control system includes a battery control apparatus 510 and the battery control apparatus 510 includes a voltage detector 511, a temperature detector 512, a current detector 513, a voltage measuring unit 521, a temperature measuring unit 522, a current measuring unit 523, an SOC calculation unit 524, an average SOC calculation unit 525, an average temperature calculation unit 526, a cycle number calculation unit 527, a storage apparatus 528, a degradation calculation unit 529, a life determination unit 561, and a communication interface 562.

The battery control apparatus 510 includes a function to make a notification of warning when degradation of a battery reaches the threshold. The warning notification function described here can be combined with any of the embodiments described above.

The life determination unit 561 receives a calculation result of the degradation calculation unit 529 and if the calculation result reaches a preset threshold (life), determines that the end of life is reached and the communication interface 562 notifies the outside (such as the host system) that the end of life is reached. This is an example of a life end notification function and instead of the communication interface 562, a "patrol lamp", a "buzzer" or the like may be included to make a notification of the end of life by turning on the lamp or sounding the buzzer.

### (Embodiment 6-1) Life prediction function 1

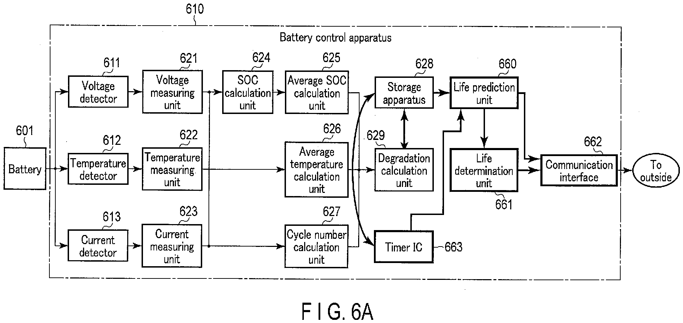

As shown in FIG. 6A, FIG. 6A is a block diagram showing an example of a battery control system according to Embodiment 6-1. As shown in FIG. 6A, the battery control system includes a battery control apparatus 610 and the battery control apparatus 610 includes a voltage detector 611, a temperature detector 612, a current detector 613, a voltage measuring unit 621, a temperature measuring unit 622, a current measuring unit 623, an SOC calculation unit 624, an average SOC calculation unit 625, an average temperature calculation unit 626, a cycle number calculation unit 627, a storage apparatus 628, a degradation calculation unit 629, a life prediction unit 660, a life determination unit 661, a communication interface 662, and a timer IC 663.

The battery control apparatus 610 includes, in addition to the calculation of the present degradation of a battery, a life prediction function to calculate the life prediction of the battery in accordance with continued use of the battery. The life prediction function described here can be combined with any of the embodiments described above.

For example, the battery control apparatus 610 predicts future degradation and the life based on the degradation trend from the start of using a battery to the present. For example, the life is predicted as described below:
(1) The storage apparatus 628 stores a calculation result by the degradation calculation unit 629 together with the calculation time. That is, the storage apparatus 628 stores a plurality of calculation results as a combination of <calculation time, calculation result>. The time counted by the timer IC 663 is adopted as a calculation time.
(2) The life prediction unit 660 reads one combination from the storage apparatus 628 when the predicted timing comes to conduct regression analysis of the relationship between the calculation time and calculation result thereof (to determine an approximation representing the relationship).
(3) Further, the life prediction unit 660 calculates degradation after a prediction period passes from the present from the preset prediction period (ex. after one year) and a regression analysis result determined in (2).
(4) The life determination unit 661 compares the prediction result calculated by the life prediction unit 660 and the preset threshold and determines that the end of life is near if the threshold is reached and the communication interface 662 notifies the outside that the end of life is near.

The predicted timing of the life prediction unit 660 may be every month based on input from the timer IC 663 or an instruction of predicted timing may be received from the host system via the communication interface 662. Further, the prediction period and the threshold used to determine as an end of life may be received from the host system via the communication interface.

### (Embodiment 6-2) Life prediction function 2

The battery control apparatus 610 predicts future degradation from use conditions (the temperature and a charge and discharge pattern) of a battery to determine the life thereof. Embodiment 6-2 is different from Embodiment 6-1 in processing of the life prediction unit 660 and data recorded in the storage apparatus 628 attached thereto. Hereinafter, the difference will be described (processing of predicted timing and processing of determination or notification of a life prediction result are the same as in Embodiment 6-1).

### (Embodiment 6-2-1) When use conditions=use condition map for each temperature/SOC of a battery

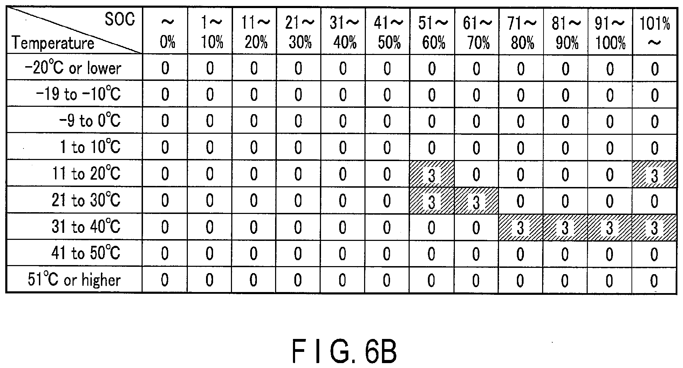

When, as shown in FIG. 6B, use conditions are a use condition map for each temperature/SOC of a battery, the map is, for example, a table showing in which ratio the battery exists per unit time for each combination of the temperature/SOC.
(1) As the unit time, one hour, one day, one month and the like can be cited.
(2) The residence ratio of the SOC and temperature is classified like, for example, "SOC: in increments of 10%" and "temperature: in increments of 10 degrees".

FIG. 6B shows an example of the use condition map describing a use method table per day when the unit time is one hour. Here, the table shows the residence time and the unit of values in Table 6B is [hour], but the values may also be represented as ratios [%]. The number of times of charge/discharge is separately prepared as the "number of times". However, the period is adjusted to the residence ratio of the SOC and temperature and if the residence ratio is per day as described above, the number of times of charge/discharge is adjusted to the "number of times of charge/discharge per day".

When the use condition map shown in FIG. 6B is given, in the case of, for example, the battery capacity, the coefficient per day=24 hours is calculated as described below by combining with the coefficient table shown in FIG. 1B.
(1) Portions of 0 hour in the use condition map are excluded from the calculation of change.
(2) The total of changes of portions that are not 0 hour in the use condition map becomes a decrease in battery capacity per day.

For example, when there is 3 hours at the temperature: 11 to 20°C and the SOC: 51 to 60%, a decrease in battery capacity is calculated as described below from the coefficient table shown in FIG. 1B.
(1) The temperature and SOC are assumed to be 15°C and 55%, which are center values in respective ranges.
(2) Calculate the coefficient of 15°C, 55% by a linear approximation of values of 10, 20°C and 50, 75% of the coefficient table in FIG. 1B. For example, the value of 20°C, 55% can be calculated as "(((value of 20°C, 75%) - (value of 20°C, 50%)) / (75-50))*(55-50) + (value of 20°C, 50%)", that is, 22. By repeating this type of calculation, "16" is obtained as the value of 15°C, 55%.
(3) The unit of values of the coefficient table in FIG. 1B is "mAh/day" and thus, the amount of change per day is given by 16*3/24=2 mAh.
(4) If any number other than 0 is in other areas of the use condition map, a similar calculation is performed for such a number and the total of calculation results is set as a change (decrease) in battery capacity per day

The degradation calculation unit 629 calculates degradation based on, as described above, the use condition map. Similar calculations are also performed concerning the cell thickness and resistance.

The life prediction unit 660 repeatedly calculates how degradation proceeds (ex. how the capacity decreases) when the use method defined in the use condition map is repeated. Further, in cooperation with the life determination unit 661, the life prediction unit 660 calculates a period when the preset threshold is reached and the communication interface 662 notifies the host system of the life prediction.

If, for example, the degradation calculation unit 629 calculates that the battery capacity decreases by 48 mAh per day, the life prediction unit 660 calculates that the battery capacity decreases by 48x2=96 mAh in two days and by 48x3=144 mAh in three days. The life determination unit 661 receives the calculation result each time and, if the preset threshold is "when the capacity decreases by 10,000 mAh", the capacity decrease exceeds 10,000 mAh after 209 days and thus, determines that the battery can be used for 208 days (determines that the end of life is reached after 209 days) and the communication interface 662 notifies the host system that the battery can be used for 208 days (the end of life is reached after 209 days).

### (Embodiment 6-2-2) When use conditions=ambient temperature and change and discharge patterns

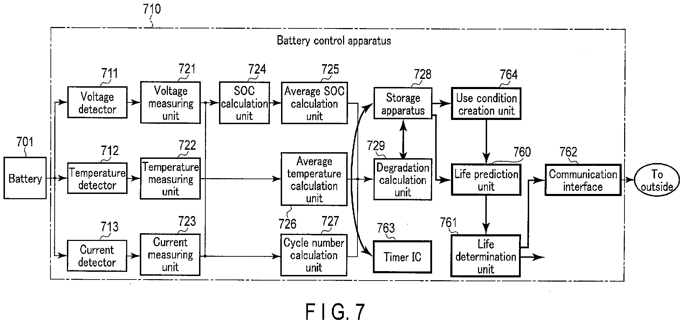

FIG. 7 is a block diagram showing an example of a battery control system according to Embodiment 6-2-2. As shown in FIG. 7, the battery control system includes a battery control apparatus 710 and the battery control apparatus 710 includes a voltage detector 711, a temperature detector 712, a current detector 713, a voltage measuring unit 721, a temperature measuring unit 722, a current measuring unit 723, an SOC calculation unit 724, an average SOC calculation unit 725, an average temperature calculation unit 726, a cycle number calculation unit 727, a storage apparatus 728, a degradation calculation unit 729, a life prediction unit 760, a life determination unit 761, a communication interface 762, a timer IC 763, and a use condition creation unit 764.

In Embodiment 6-2-2, a case when use conditions are the ambient temperature and a charge and discharge pattern will be described. Embodiment 6-2-2 is the same as Embodiment 6-2-1 in the calculation by the degradation calculation unit 729 and thereafter (the life prediction unit 760 and the life determination unit 761) and thus, the description thereof is omitted here. In other words, how to create a use condition map as shown in Embodiment 6-2-1 from the ambient temperature and the charge and discharge pattern will be described here.

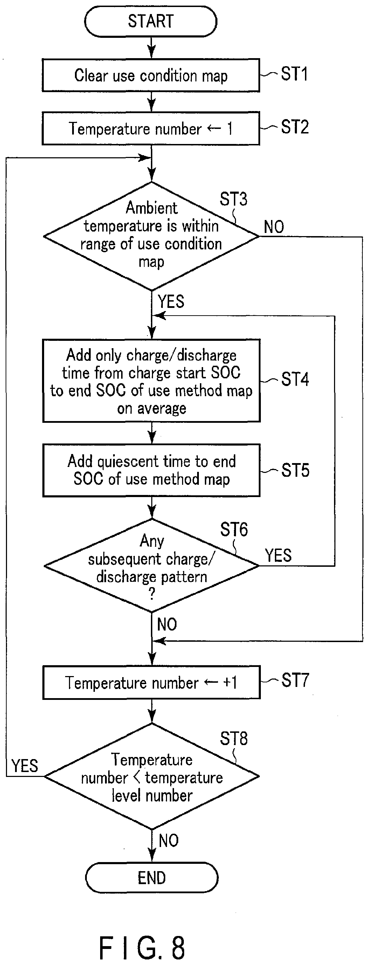

As a charge and discharge pattern, for example, "charge/discharge SOC range", "charge/discharge time", and "quiescent time" are combined. As shown in FIG. 8, the use condition creation unit 764 creates a use condition map.

For example, the use condition creation unit 764 clears a use condition map (ST1), sets the temperature number to the initial value "1" (ST2), and if the ambient temperature is within the range of the use condition map (ST3, YES), adds only a charge/discharge time from the charge/discharge start SOC to the charge/discharge end SOC on average (ST4), and adds a charge/discharge quiescent time to the charge/discharge end SOC of the use method map (ST5). If there is any subsequent charge and discharge pattern (ST6, YES), the use condition creation unit 764 repeats ST4 and ST5 and if there is no subsequent charge and discharge pattern (ST6, NO), the use condition creation unit 764 increments the temperature number (+1)(ST7), repeats ST3 to ST7 until the temperature number reaches a temperature level number, and when the temperature number reaches the temperature level number (ST8, NO), finishes the creation of a use condition map.

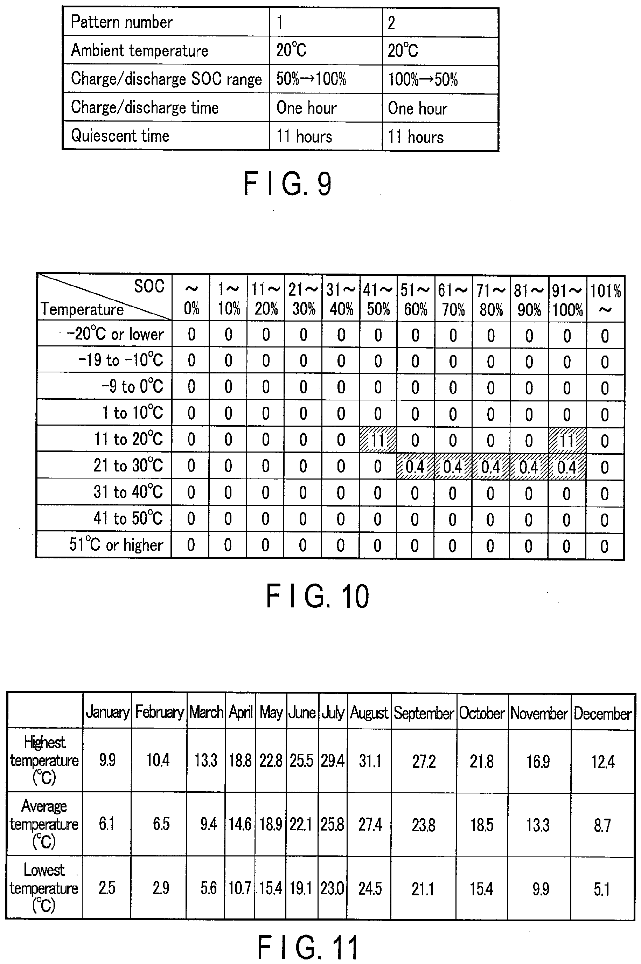

If, for example, use conditions shown in FIG. 9 are given, the use condition creation unit 764 creates a use condition map shown in FIG. 10 as use conditions for a battery per day. Use conditions shown in FIG. 9 show the repetition of a charge and discharge pattern in which the battery is charged from SOC: 50% to 100% in one hour and after 11 hours of pause, the battery is discharged from SOC: 100% to 50% in one hour before taking a pause of 11 hours.

Because there are pauses of 11 hours in SOC: 100% and 50%, the use condition creation unit 764 records 11 hours also in the use condition map shown in FIG. 10. Also, the use condition creation unit 764 allocates one hour of charge time to SOC on average in the charge of SOC: 500% → 100% and allocates one hour/5=0.2 hours in increments of 10%. This also applies to the discharge side. Because the battery temperature is higher than the ambient temperature during charging/discharging, 0.2 + 0.2 =0.4 hours are allocated to portions higher than the ambient temperature for 50 → 100% and 100 → 50%. The temperature rise width can be calculated based on temperature rise characteristics obtained by experiment in advance.

When a charge/discharge current changes, the change can be reflected in the charge/discharge time. This can be implemented by, for example, allocating one hour for 50% → 75% and 0.5 hours for 75% → 100%.

A case when the use condition creation unit 764 refers to a use condition map stored in the storage apparatus 728 is described, but the use condition creation unit 764 may also refer to a use condition map provided from outside via the communication interface 762. In this case, when use conditions change, how the life changes can also be estimated.

### (Embodiment 6-2-2-1) When a used city name is given, instead of the ambient temperature, as a use condition

When a used city name is given as a use condition, a battery control apparatus 710 can create a use condition map based on the used city name. In this case, a storage apparatus 728 holds temperature data for each used city and a use condition creation unit 764 searches for temperature data based on the used city name. Accordingly, the used city name (use area) can be converted into an ambient use temperature.

For example, the storage apparatus 728 holds temperature data (from http://weather.time-j.net/Climate/Chart/tokyo) as shown in FIG. 11 for each used city name (use area) and the use condition creation unit 764 substitutes an ambient use temperature for the given used city name (use area) based on stored data for each used city name (use area) and the given used city name (use area).

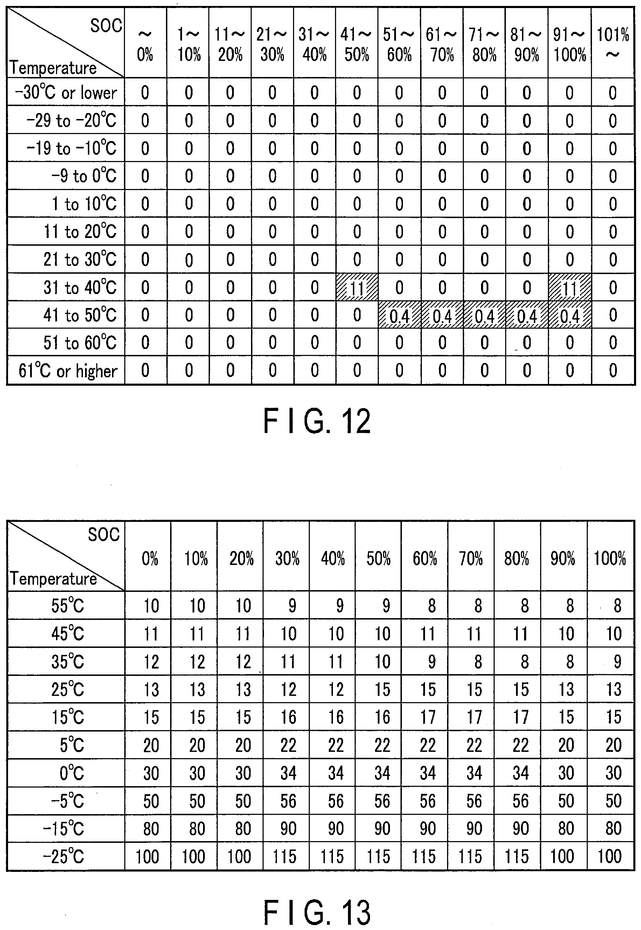

For example, the use condition creation unit 764 creates a use condition map shown in FIG. 12 based on the use conditions in FIG. 9 and temperature data shown in FIG. 11. For example, the highest temperature in August is 31.1°C and so a use condition map is created by setting the temperature as the ambient temperature. In consideration of the fact that degradation of a battery increases with a rising temperature, the highest temperature is set as the ambient temperature, but the average temperature may be set as the ambient temperature or the highest temperature, the average temperature, and the lowest temperature may be arranged chronologically.

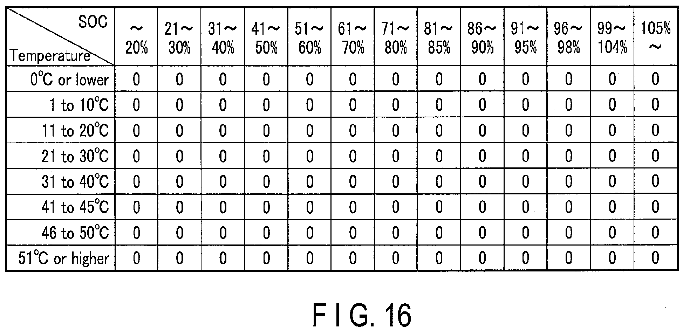

Here, another example of the use condition map that can be used in Embodiment 6-2-1, Embodiment 6-2-2, and Embodiment 6-2-2-1 will be described with reference to FIG. 16.

In the use condition map described above, the distribution of the temperature and SOC is set at regular intervals (temperature: 10°C, SOC: 10%), but depending on performance of a battery or the like, the distribution of the temperature and SOC in the use condition table may be defined so as not to be at regular intervals. For example, if the degradation speed is small at low temperature or in low SOC and the absolute value thereof hardly changes, areas of low temperature or low SOC may be merged. Also, if the trend of degradation changes finely at high temperature or in high SOC, such an area may be divided.

For example, FIG. 16 shows an example of the use condition map in which areas of the temperature 0°C or lower are merged, areas of SOC 20% or less are merged, areas of the temperature 41°C or higher are divided, and areas of SOC 81% or more are divided. Merging can reduce the cost of creating a use condition map and lessen the amount of processing and dividing can improve degradation estimation precision based on a use condition map.

### (Embodiment 6-2-2-2) When the life is predicted by taking degradation (resistance increase) caused by the use of a battery into account

The battery control apparatus 710 predicts the life of a battery by taking degradation (resistance increase) caused by the use of a battery into account. The storage apparatus 728 holds an internal resistance map. The battery control apparatus 710 includes a temperature rise calculation unit that calculates a temperature rise from internal resistance and the temperature rise calculation unit updates the internal resistance map for each degradation calculation and calculates a temperature rise from an internal resistance increase (due to advancing degradation in the future) when the life is predicted.

The internal resistance map is an initial internal resistance map (evaluation data) when the battery is shipped and the storage apparatus 728 holds the internal resistance map. For example, the internal resistance map is prepared for each combination of the SOC and temperature. FIG. 13 is a diagram showing an example of the internal resistance map.

When the temperature rise width is calculated from internal resistance, the temperature rise coefficient recorded in the storage apparatus 728 and a current value (calculated from the charge/discharge SOC range and the charge/discharge time) that can be calculated from a charge and discharge pattern are used. This is because the temperature rise due to charging/discharging of a battery obeys the Joule's law (proportional to the product of the square of the current value and the internal resistance value).

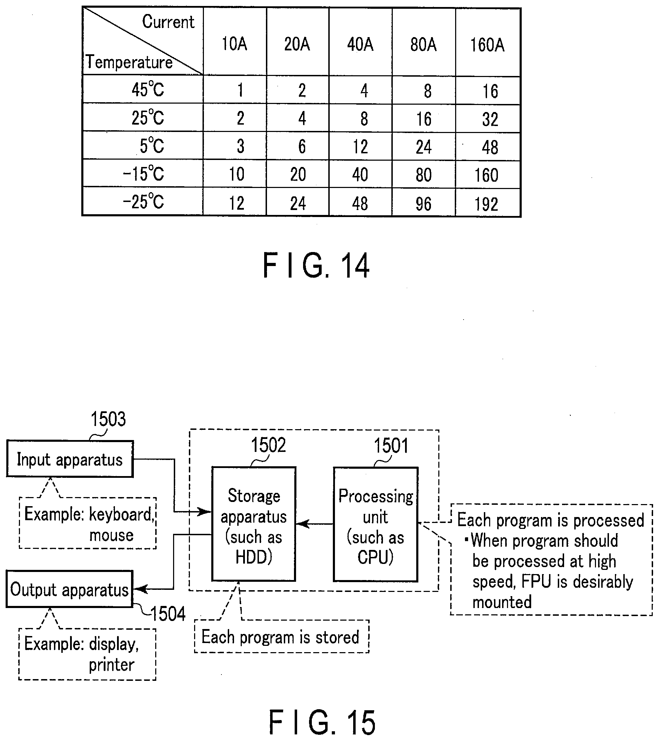

As an example of the temperature rise coefficient, a table determined by the current value and the temperature can be considered. FIG. 14 is a diagram showing an example of the table showing temperature rise coefficients.

For example, when charged/discharged at 20 A in SOC 30% in the environment of 25°C, the temperature rise calculation unit calculates the current x current x internal resistance x coefficient (20 x 20 x 12 x 4 = 19200 → rises by 1.92°C). This is an example of the calculation method of temperature rise and other methods may also be adopted.

When internal resistance rises after a degradation calculation, the battery control apparatus 710 updates the internal resistance map. Accordingly, the temperature rise width also increases and the internal resistance rise due to degradation → temperature rise → acceleration of degradation can be estimated so that the precision of life prediction is improved.

Incidentally, Embodiment 6-2-2-1 and Embodiment 6-2-2-2 may be combined so that an internal resistance map is used after a used city is accepted as input.

In the internal resistance map shown in FIG. 13, the distribution of SOC is set at regular intervals of 10%, but depending on performance of a battery or the like, the distribution of SOC in the internal resistance map may be defined so as not to be at regular intervals. If, for example, the internal resistance is the same or the change of the internal resistance is a constant rate in accordance with change of SOC, an approximation can be used for calculation.

In the table shown above, for example, the value of internal resistance is the same for SOC: 0, 10, 20% and thus, SOC: 10% can be omitted (because an approximate calculation can be performed from values of SOC: 0, 20%). In this manner, the size of the internal resistance map, that is, the memory size of the battery control apparatus to store the internal resistance map can be reduced and thus, the cost of the battery control apparatus can be lowered.

On the other hand, in consideration of the possibility that changes due to degradation of internal resistance are not uniform, allowing the distribution of the temperature and SOC of the internal resistance map to be at regular intervals from the beginning can be considered. In this case, lower costs cannot be achieved, but degradation estimation precision can be maintained even if the internal resistance changes.

### (Embodiment 6-3)

In the foregoing, a case when the battery control apparatus 710 predicts the life is described, but the host system may also predict the life. In this case, the host system includes a life prediction unit, a life determination unit, a use condition creation unit, and a storage apparatus and each unit of the host system cooperate to predict the life.

### (Embodiment 7) External programming of the degradation calculation and life estimation

Processing such as the degradation calculation and life estimation may be performed inside the battery control apparatus or the processing may be converted into a program so that the program is installed on a computer (such as an external PC) and executed thereon.

FIG. 15 is a diagram showing an example of an outline configuration of the computer.

As shown in FIG. 15, the computer includes a processing unit 1501, a storage apparatus 1502, an input apparatus 1503, and an output apparatus 1504. The processing unit 1501 is constructed of a processor such as CPU, the storage apparatus 1502 is constructed of HDD and the like, the input apparatus 1503 is constructed of a keyboard, a mouse and the like, and the output apparatus 1504 is constructed of a display, a printer and the like. The storage apparatus 1502 stores the program and the processing unit 1501 executes the program.

The storage apparatus 1502 also stores information (a coefficient table and a use condition map) needed for the degradation calculation and life estimation. Alternatively, the computer includes a communication apparatus and the communication apparatus transmits and receives information needed for the degradation calculation and life estimation via a network.

According to the computer, the degradation calculation and life estimation can be implemented relatively easily and if the used city or used charge and discharge pattern of the computer is known, the life of a battery can be estimated and so can be used to review (examine) the charge and discharge pattern to prolong the life.

According to at least one embodiment described above, the following operations/effects can be obtained:
(1) A calculation can be performed by considering up to a time when an apparatus monitoring a battery is stopped.
   When the apparatus monitoring the battery is stopped → restarted, the battery control apparatus calculates degradation when restarted based on the stop interval recorded by one of methods of (1-1) to (1-3) and the temperature and SOC of the battery while stopped.
   (1-1) The time and temperature while the battery control apparatus is stopped is monitored from the host system side. The SOC while stopped is SOC when the apparatus is stopped or restarted.
   (1-2) The stop of the battery control apparatus is replaced with the low-power mode and the time measured by a timer separately provided in the apparatus or the like is set as a stop interval. The battery temperature and SOC while stopped are those when stopped or restarted.
   (1-3) The time while the battery control apparatus is stopped is calculated by a monitoring apparatus from a voltage difference of the battery when stopped and when restarted and a self-discharged amount rate map. The temperature while stopped is the temperature when the apparatus is stopped or restarted.
(2) A calculation can be performed in consideration of differences of the degradation speed due to different charge/discharge SOC ranges.

The battery control apparatus measures the current in advance and determines whether charged/discharged or the charge/discharge is stopped in accordance with the magnitude of the current. Further, while charged/discharged, the number of cycles or charge/discharge time is calculated from the charged/discharged amount and also the maximum, minimum, and average SOC are the like while charged/discharged are recorded. By changing the table for degradation calculation in accordance with the SOC range while charged/discharged, a case when the charge/discharge range is different is dealt with.
(3) By estimating degradation also in consideration of the acceleration of degradation with an increasing temperature rise width accompanying a resistance increase, the precision of degradation estimation is improved.

How the degradation of a secondary battery that changes depending on the ambient use temperature of the battery, the charge/discharge range, and the number of times of charge/discharge proceeds can be calculated so that the influence of battery degradation on the operation of a system using the battery can be reduced.

Incidentally, processing of each unit of the battery control apparatuses 110, 210, 310, 410, 510, 610, 710 and the host system 240 may be performed by a processor.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

### REFERENCE SIGNS LIST

- 10:: Electron
- 110:: Battery control apparatus
- 111:: Voltage detector
- 112:: Temperature detector
- 113:: Current detector
- 121:: Voltage measuring unit
- 122:: Temperature measuring unit
- 123:: Current measuring unit
- 124:: SOC calculation unit
- 125:: Average SOC calculation unit
- 126:: Average temperature calculation unit
- 127:: Cycle number calculation unit
- 128:: Storage apparatus
- 129:: Degradation calculation unit

## Claims

1. A degradation estimation method comprising:
detecting a stop interval of a battery control apparatus configured to be able to calculate a state of charge of a battery; and
acquiring degradation information corresponding to a calculated state of charge calculated from the battery and a detection temperature detected from the battery or degradation information corresponding to the calculated state of charge and an ambient temperature based on a first degradation information database showing degradation of the battery in accordance with a set state of charge and a set temperature, and estimating the degradation of the battery in the stop interval based on the degradation information acquired.

2. The degradation estimation method according to claim 1, wherein
a stop monitoring apparatus configured to be able to communicate with the battery control apparatus detects an ambient temperature while the battery control apparatus is stopped, detects the stop interval from a stop time and a restart time of the battery control apparatus, and notifies the battery control apparatus of the stop interval and the ambient temperature after the battery control apparatus is restarted and
the battery control apparatus calculates the state of charge of the battery for at least one of before being stopped and after being restarted, acquires the degradation information corresponding to the calculated state of charge and the ambient temperature based on the first degradation information database, and estimates the degradation of the battery in the stop interval based on the degradation information acquired.

3. The degradation estimation method according to claim 1, wherein
the battery control apparatus includes a timer capable of operating while the battery control apparatus is stopped, the timer detects the stop interval, and
the battery control apparatus detects the state of charge and a temperature of the battery for at least one of before being stopped and after being restarted, acquires the degradation information corresponding to the calculated state of charge and the detection temperature based on the first degradation information database, and estimates the degradation of the battery in the stop interval based on the degradation information acquired.

4. The degradation estimation method according to claim 1, wherein the battery control apparatus detects the stop interval based on self-discharged amount rate information of the battery and a differential voltage between a voltage of the battery before being stopped and the voltage of the battery after being restarted, calculates the state of charge of the battery for at least one of before being stopped and after being restarted and detects a temperature, acquires the degradation information corresponding to the calculated state of charge and the detection temperature based on the first degradation information database, and estimates the degradation of the battery in the stop interval based on the degradation information acquired.

5. The degradation estimation method according to any one of claims 1 to 4, wherein the battery control apparatus calculates a charge of state variation range due to charge/discharge of the battery and detects the temperature and acquires the degradation information corresponding to a calculated state of charge variation range calculated from the battery and the detection temperature detected from the battery based on a second degradation information database showing the degradation of the battery in accordance with a set state of charge variation range and the set temperature to estimate the degradation of the battery while being charged/discharged based on the degradation information acquired.

6. The degradation estimation method according to any one of claims 1 to 5, wherein when the degradation reaches a threshold based on estimation of the degradation, the battery control apparatus outputs information showing the degradation of the battery.

7. The degradation estimation method according to any one of claims 1 to 6, wherein the battery control apparatus detects a degradation trend of the battery including the estimation of the degradation and predicts a life of the battery based on the degradation trend detected.

8. The degradation estimation method according to any one of claims 1 to 7, wherein the battery control apparatus analyzes use conditions of the battery in a fixed period in accordance with the calculated state of charge and the detection temperature and estimates the degradation of the battery based on the use conditions and the first degradation information database.

9. The degradation estimation method according to any one of claims 1 to 7, wherein the battery control apparatus analyzes use conditions of the battery including a charge/discharge time of the battery, a maximum value and a minimum value of the state of charge variation range due to the charge/discharge, the ambient temperature while being charged/discharged, and a charge/discharge quiescent time and estimates a rise of the detection temperature while being charged/discharged from an internal resistance database showing changes in internal resistance of the battery corresponding to the use conditions and the detection temperature to estimate the degradation of the battery based on the use conditions and the first degradation information database.

10. The degradation estimation method according to claim 9, wherein based on correspondence data between a city name and the ambient temperature, the ambient temperature corresponding to the city name is set in response to input of the city name.

11. The degradation estimation method according to claim 9, wherein the battery control apparatus estimates a temperature rise value of the battery while being charged/discharged based on changes in internal resistance of the battery due to the charge/discharge of the battery and estimates the degradation of the battery based on an estimated temperature rise.

12. A degradation estimation system comprising:
a battery control apparatus configured to be able to calculate a state of charge of a battery; and
a stop interval detection apparatus configured to be able to detect a stop interval of the battery control apparatus, wherein
the battery control apparatus acquires degradation information corresponding to a calculated state of charge calculated from the battery and a detection temperature detected from the battery or degradation information corresponding to the calculated state of charge and an ambient temperature based on a first degradation information database showing degradation of the battery in accordance with a set state of charge and a set temperature, and estimates the degradation of the battery in the stop interval based on the degradation information acquired.

13. A degradation estimation program causing a computer to execute procedures comprising:
detecting a stop interval of a battery control apparatus configured to be able to calculate a state of charge of a battery; and
acquiring degradation information corresponding to a calculated state of charge calculated from the battery and a detection temperature detected from the battery or degradation information corresponding to the calculated state of charge and an ambient temperature based on a first degradation information database showing degradation of the battery in accordance with a set state of charge and a set temperature, and estimating the degradation of the battery in the stop interval based on the degradation information acquired.

14. A degradation estimation program causing a computer to execute procedures comprising:
analyzing use conditions of a battery including a charge/discharge time of the battery, a maximum value and a minimum value of a state of charge variation range due to charge/discharge, an ambient temperature while being charged/discharged, and a charge/discharge quiescent time;
calculating a battery temperature from the ambient temperature while being charged/discharged;
reflecting internal resistance whose degradation is estimated based on the use conditions in the procedure for calculating the battery temperature;
creating a use condition map from the use conditions and the battery temperature calculated; and
estimating degradation of the battery based on the use condition map and a first degradation information database showing the degradation of the battery.
